# EUROPEAN PATENT SPECIFICATION

(11) **EP 1 952 674 B1**
(45) Date of publication and mention of the grant of the patent: **09.09.2015**
(21) Application number: 06799059.8
(22) Date of filing: 02.10.2006
(51) Int. Cl.: G10L 19/008, G10L 19/18

(54) **Compensation of a decoding delay of a multi-channel audio signal**
Ausgleich von einer Dekodierverzögerung eines Mehrkanal-Tonsignals
Compensation d'un délai de décodage pour un signal audio multi-canal

(30) Priority: 24.10.2005 US 729225 P; 09.01.2006 US 757005 P; 29.03.2006 US 786740 P; 17.04.2006 US 792329 P; 18.08.2006 KR 20060078218; 18.08.2006 KR 20060078221; 18.08.2006 KR 20060078222; 18.08.2006 KR 20060078223; 18.08.2006 KR 20060078225; 18.08.2006 KR 20060078219
(43) Date of publication of application: 06.08.2008
(73) Proprietor: LG Electronics Inc., Seoul 150-721 (KR)
(72) Inventor: PANG, Hee Suck, Seoul 137-724 (KR); KIM, Dong Soo, Seoul 151-801 (KR); LIM, Jae Hyun, Seoul 151-801 (KR); OH, Hyen O, Gyeonggi-do 411-744 (KR); JUNG, Yang Won, Seoul 135-270 (KR)
(74) Representative: Katérle, Axel
(86) International application number: PCT/KR2006/003976
(87) International publication number: WO 2007/049865

(56) References cited:
- HERRE J ET AL: "MP3 Surround: Efficient and Compatible Coding of Multi-Channel Audio" AUDIO ENGINEERING SOCIETY. CONVENTION PREPRINT, XX, XX, 8 May 2004 (2004-05-08), pages 1-14, XP002338414
- WEBB J. AND LUECK J.: 'Video and audio coding for mobile applications' THE APPLICATION OF PROGRAMMABLE DSPS IN MOBILE COMMUNICATIONS 2002, pages 179 - 200, XP003012495
- BOLTZE TH. ET AL.: 'Audio services and applications' DIGITAL AUDIO BRAODCASTING 2003, pages 75 - 83, XP003012496
- FALLER CH.: 'Parametric coding of spatial audio' DOCTORAL THESIS, ECOLE POLYTECHNIQUES FEDERALE DE LAUSANNE vol. 3062, 2004, XP002343263
- "Text of ISO/IEC 23003-1:200x MPEG Surround", 74. MPEG MEETING;17-10-2005 - 21-10-2005; NICE; (MOTION PICTURE EXPERTGROUP OR ISO/IEC JTC1/SC29/WG11),, no. N7530, 21 October 2005 (2005-10-21), XP030014078, ISSN: 0000-0344
- ALEXANDER GRÖSCHEL ET AL: "Proposed corrections to time alignment of downmix and spatial data in MPEG Surround", 77. MPEG MEETING; 17-07-2006 - 21-07-2006; KLAGENFURT; (MOTION PICTUREEXPERT GROUP OR ISO/IEC JTC1/SC29/WG11),, no. M13663, 12 July 2006 (2006-07-12), XP030042332, ISSN: 0000-0236
- QUACKENBUSH S: "AHG on MPEG Surround", 77. MPEG MEETING; 17-07-2006 - 21-07-2006; KLAGENFURT; (MOTION PICTUREEXPERT GROUP OR ISO/IEC JTC1/SC29/WG11),, no. M13404, 17 July 2006 (2006-07-17), XP030042073, ISSN: 0000-0236

## Description

### Technical Field

The disclosed embodiments relate generally to signal processing.

### Background Art

Multi-channel audio coding (commonly referred to as spatial audio coding) captures a spatial image of a multi-channel audio signal into a compact set of spatial parameters that can be used to synthesize a high quality multi-channel representation from a transmitted downmix signal.

In a multi-channel audio system, where several coding schemes are supported, a downmix signal can become time delayed relative to other downmix signals and/or corresponding spatial parameters due to signal processing (e.g., time-to-frequency domain conversions).

"Text of ISO/IEC 14496-3:200X/PDAM 4, MPEG Surround" (N7530, October 2005, Nice, France) describes the MPEG Surround standard (Spatial Audio Coding, SAC), that is capable of re-creating N channels based on M<N transmitted channels, and additional control data.

"Proposed correction to time alignment of downmix and spatial data in MPEG Surround" (Alexander Gröschel, et al.; M13663, July 2006, Klagenfurt, Austria) describes embedding spatial parameter data in a bitstream carrying the downmix data with a modified time alignment that minimizes memory requirements and makes parameter decoder easier for a low-power decoder. Spatial parameter data and residual data is embedded in the bitstream such that no additional delay of parameters and residual signals is needed for a low power decoder.

"Report of AhG on MPEG Surround" (S. Quackenbush, M13404, July 2006, Klagenfurt, Austria) describes incorporating a compensating delay between spatial information and audio parameters when decoding, in a "high quality" mode, a signal encoded in a "low quality" mode.

### Disclosure of Invention

The object of the present invention can be achieved by the method and apparatus of the claims

### Brief Description of Drawings

The accompanying drawings, which are included to provide a further understanding of the invention and are incorporated in and constitute a part of this application, illustrate embodiment(s) of the invention and together with the description serve to explain the principle of the invention. In the drawings:
FIGS. 1 to 3 are block diagrams of apparatuses for decoding an audio signal according to examples;
FIG. 4 is a block diagram of a plural-channel decoding unit shown in FIG. 1 to explain a signal processing method;
FIG. 5 is a block diagram of a plural-channel decoding unit shown in FIG. 2 to explain a signal processing method; and
FIGS. 6 to 8 are block diagrams to explain a method of decoding an audio signal according to examples
Fig. 9 is a block diagram according to an embodiment of the invention
Fig. 10 is a block diagram of a further example.

### Best Mode for Carrying Out the Invention

Reference will now be made in detail to the preferred embodiments of the present invention, examples of which are illustrated in the accompanying drawings. Wherever possible, the same reference numbers will be used throughout the drawings to refer to the same or like parts.

Since signal processing of an audio signal is possible in several domains, and more particularly in a time domain, the audio signal needs to be appropriately processed by considering time alignment.

Therefore, a domain of the audio signal can be converted in the audio signal processing. The converting of the domain of the audio signal maybe include a T/F(Time/Frequency) domain conversion and a complexity domain conversion. The T/F domain conversion includes at least one of a time domain signal to a frequency domain signal conversion and a frequency domain signal to time domain signal conversion. The complexity domain conversion means a domain conversion according to complexity of an operation of the audio signal processing. Also, the complexity domain conversion includes a signal in a real frequency domain to a signal in a complex frequency domain, a signal in a complex frequency domain to a signal in a real frequency domain, etc. If an audio signal is processed without considering time alignment, audio quality may be degraded. A delay processing can be performed for the alignment. The delay processing can include at least one of an encoding delay and a decoding delay. The encoding delay means that a signal is delayed by a delay accounted for in the encoding of the signal. The decoding delay means a real time delay introduced during decoding of the signal.

Prior to explaining the present invention, terminologies used in the specification of the present invention are defined as follows.

'Downmix input domain' means a domain of a downmix signal receivable in a plural-channel decoding unit that generates a plural-channel audio signal.

'Residual input domain' means a domain of a residual signal receivable in the plural-channel decoding unit.

'Time-series data' means data that needs time synchronization with a plural-channel audio signal or time alignment. Some examples of 'time series data' includes data for moving pictures, still images, text, etc.

'Leading' means a process for advancing a signal by a specific time.

'Lagging' means a process for delaying a signal by a specific time.

'Spatial information' means information for synthesizing plural-channel audio signals. Spatial information can be spatial parameters, including but not limited to: CLD (channel level difference) indicating an energy difference between two channels, ICC (inter-channel coherences) indicating correlation between two channels), CPC (channel prediction coefficients) that is a prediction coefficient used in generating three channels from two channels, etc.

The audio signal decoding described herein is one example of signal processing that can benefit from the present invention. The present invention can also be applied to other types of signal processing (e.g., video signal processing). The embodiments described herein can be modified to include any number of signals, which can be represented in any kind of domain, including but not limited to: time, Quadrature Mirror Filter (QMF), Modified Discreet Cosine Transform (MDCT), complexity, etc.

A method of processing an audio signal according to example includes generating a plural-channel audio signal by combining a downmix signal and spatial information. There can exist a plurality of domains for representing the downmix signal (e.g., time domain, QMF, MDCT). Since conversions between domains can introduce time delay in the signal path of a downmix signal, a step of compensating for a time synchronization difference between a downmix signal and spatial information corresponding to the downmix signal is needed. The compensating for a time synchronization difference can include delaying at least one of the downmix signal and the spatial information. Several examples for compensating a time synchronization difference between two signals and/or between signals and parameters will now be described with reference to the accompanying figures.

Any reference to an "apparatus" herein should not be construed to limit the described embodiment to hardware. The embodiments described herein can be implemented in hardware, software, firmware, or any combination thereof.

The embodiments described herein can be implemented as instructions on a computer-readable medium, which, when executed by a processor (e.g., computer processor), cause the processor to perform operations that provide the various aspects of the present invention described herein. The term "computer-readable medium" refers to any medium that participates in providing instructions to a processor for execution, including without limitation, non-volatile media (e.g., optical or magnetic disks), volatile media (e.g., memory) and transmission media. Transmission media includes, without limitation, coaxial cables, copper wire and fiber optics. Transmission media can also take the form of acoustic, light or radio frequency waves.

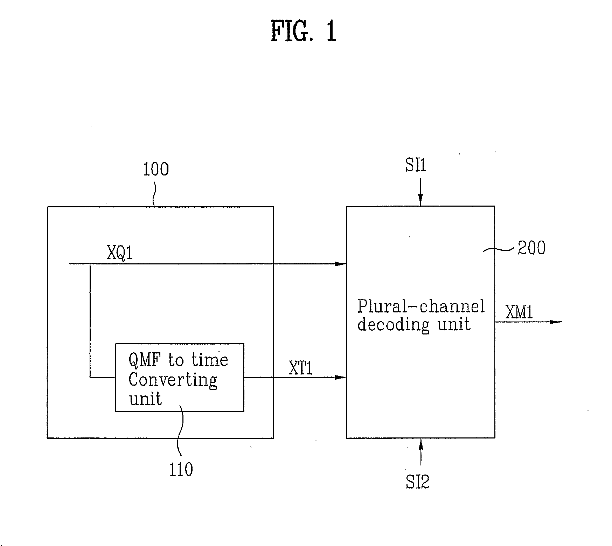

FIG. 1 is a diagram of an apparatus for decoding an audio signal according to an example.

Referring to FIG. 1, an apparatus for decoding an audio signal according to an example includes a downmix decoding unit 100 and a plural-channel decoding unit 200.

The downmix decoding unit 100 includes a domain converting unit 110. In the example shown, the downmix decoding unit 100 transmits a downmix signal XQ1 processed in a QMF domain to the plural-channel decoding unit 200 without further processing. The downmix decoding unit 100 also transmits a time domain downmix signal XT1 to the plural-channel decoding unit 200, which is generated by converting the downmix signal XQ1 from the QMF domain to the time domain using the converting unit 110. Techniques for converting an audio signal from a QMF domain to a time domain are well-known and have been incorporated in publicly available audio signal processing standards (e.g., MPEG).

The plural-channel decoding unit 200 generates a plural-channel audio signal XM1 using the downmix signal XT1 or XQ1, and spatial information SI1 or SI2.

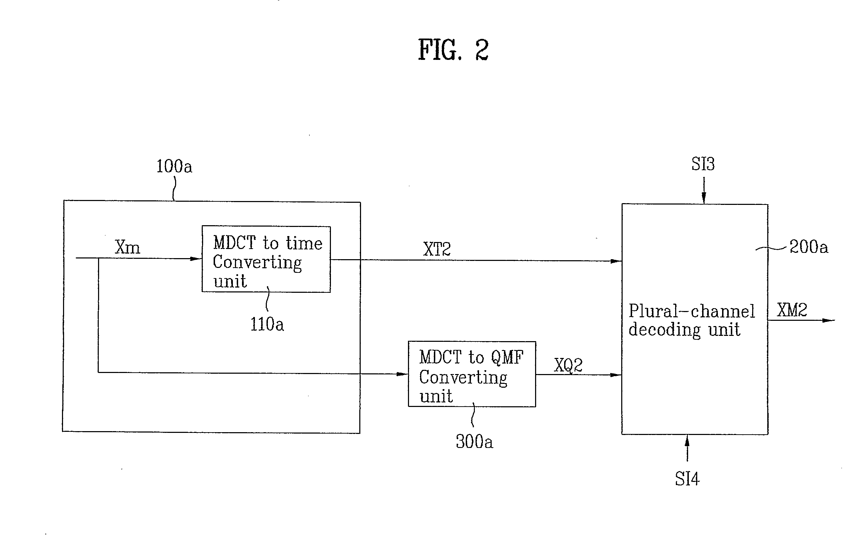

FIG. 2 is a diagram of an apparatus for decoding an audio signal according to another example.

Referring to FIG. 2, the apparatus for decoding an audio signal according to another example includes a downmix decoding unit 100a, a plural-channel decoding unit 200a and a domain converting unit 300a.

The downmix decoding unit 100a includes a domain converting unit 110a. In the example shown, the downmix decoding unit 100a outputs a downmix signal Xm processed in a MDCT domain. The downmix decoding unit 100a also outputs a downmix signal XT2 in a time domain, which is generated by converting Xm from the MDCT domain to the time domain using the converting unit 110a.

The downmix signal XT2 in a time domain is transmitted to the plural-channel decoding unit 200a. The downmix signal Xm in the MDCT domain passes through the domain converting unit 300a, where it is converted to a downmix signal XQ2 in a QMF domain. The converted downmix signal XQ2 is then transmitted to the plural-channel decoding unit 200a.

The plural-channel decoding unit 200a generates a plural-channel audio signal XM2 using the transmitted downmix signal XT2 or XQ2 and spatial information SI3 or SI4.

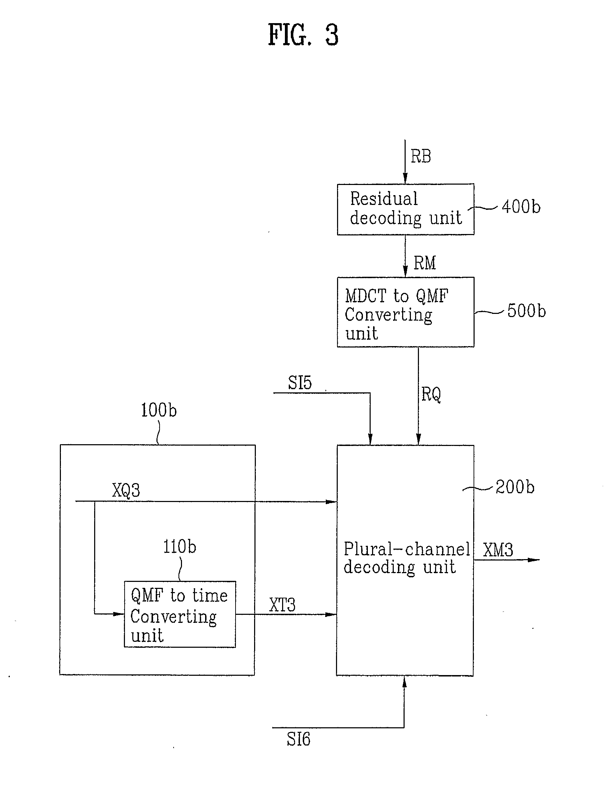

FIG. 3 is a diagram of an apparatus for decoding an audio signal according to another example.

Referring to FIG. 3, the apparatus for decoding an audio signal according to another example includes a downmix decoding unit 100b, a plural-channel decoding unit 200b, a residual decoding unit 400b and a domain converting unit 500b.

The downmix decoding unit 100b includes a domain converting unit 110b. The downmix decoding unit 100b transmits a downmix signal XQ3 processed in a QMF domain to the plural-channel decoding unit 200b without further processing. The downmix decoding unit 100b also transmits a downmix signal XT3 to the plural-channel decoding unit 200b, which is generated by converting the downmix signal XQ3 from a QMF domain to a time domain using the converting unit 110b.

In some examples, an encoded residual signal RB is inputted into the residual decoding unit 400b and then processed. In this case, the processed residual signal RM is a signal in an MDCT domain. A residual signal can be, for example, a prediction error signal commonly used in audio coding applications (e.g., MPEG).

Subsequently, the residual signal RM in the MDCT domain is converted to a residual signal RQ in a QMF domain by the domain converting unit 500b, and then transmitted to the plural-channel decoding unit 200b.

If the domain of the residual signal processed and outputted in the residual decoding unit 400b is the residual input domain, the processed residual signal can be transmitted to the plural-channel decoding unit 200b without undergoing a domain converting process.

FIG. 3 shows that in some examples the domain converting unit 500b converts the residual signal RM in the MDCT domain to the residual signal RQ in the QMF domain. In particular, the domain converting unit 500b is configured to convert the residual signal RM outputted from the residual decoding unit 400b to the residual signal RQ in the QMF domain.

As mentioned in the foregoing description, there can exist a plurality of downmix signal domains that can cause a time synchronization difference between a downmix signal and spatial information, which may need to be compensated. Various examples for compensating time synchronization differences are described below.

An audio signal process according to one example generates a plural-channel audio signal by decoding an encoded audio signal including a downmix signal and spatial information.

In the course of decoding, the downmix signal and the spatial information undergo different processes, which can cause different time delays.

In the course of encoding, the downmix signal and the spatial information can be encoded to be time synchronized.

In such a case, the downmix signal and the spatial information can be time synchronized by considering the domain in which the downmix signal processed in the downmix decoding unit 100, 100a or 100b is transmitted to the plural-channel decoding unit 200, 200a or 200b.

In some examples, a downmix coding identifier can be included in the encoded audio signal for identifying the domain in which the time synchronization between the downmix signal and the spatial information is matched. In such a case, the downmix coding identifier can indicate a decoding scheme of a downmix signal.

For instance, if a downmix coding identifier identifies an Advanced Audio Coding(AAC) decoding scheme, the encoded audio signal can be decoded by an AAC decoder.

In some examples, the downmix coding identifier can also be used to determine a domain for matching the time synchronization between the downmix signal and the spatial information.

In a method of processing an audio signal according to one example, a downmix signal can be processed in a domain different from a time-synchronization matched domain and then transmitted to the plural-channel decoding unit 200, 200a or 200b. In this case, the decoding unit 200, 200a or 200b compensates for the time synchronization between the downmix signal and the spatial information to generate a plural-channel audio signal.

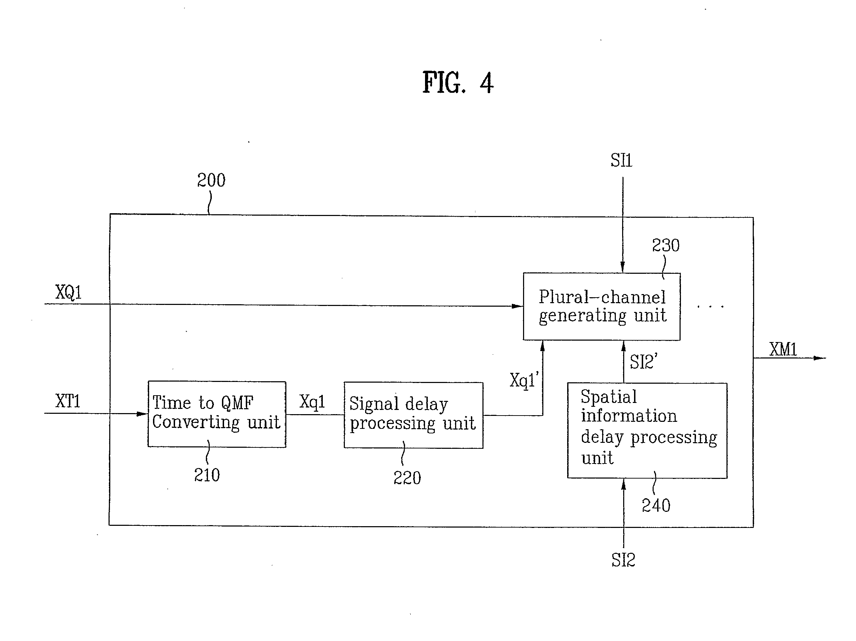

A method of compensating for a time synchronization difference between a downmix signal and spatial information is explained with reference to FIG. 1 and FIG. 4 as follows.

FIG. 4 is a block diagram of the plural-channel decoding unit 200 shown in FIG. 1.

Referring to FIG. 1 and FIG. 4, in a method of processing an audio signal according to one example, the downmix signal processed in the downmix decoding unit 100 (FIG. 1) can be transmitted to the plural-channel decoding unit 200 in one of two kinds of domains. In the present embodiment, it is assumed that a downmix signal and spatial information are matched together with time synchronization in a QMF domain. Other domains are possible.

In the example shown in FIG. 4, a downmix signal XQ1 processed in the QMF domain is transmitted to the plural-channel decoding unit 200 for signal processing.

The transmitted downmix signal XQ1 is combined with spatial information SI1 in a plural-channel generating unit 230 to generate the plural-channel audio signal XM1.

In this case, the spatial information SI1 is combined with the downmix signal XQ1 after being delayed by a time corresponding to time synchronization in encoding. The delay can be an encoding delay. Since the spatial information SI1 and the downmix signal XQ1 are matched with time synchronization in encoding, a plural-channel audio signal can be generated without a special synchronization matching process. That is, in this case, the spatial information ST1 is not delayed by a decoding delay.

In addition to XQ1, the downmix signal XT1 processed in the time domain is transmitted to the plural-channel decoding unit 200 for signal processing. As shown in FIG. 1, the downmix signal XQ1 in a QMF domain is converted to a downmix signal XT1 in a time domain by the domain converting unit 110, and the downmix signal XT1 in the time domain is transmitted to the plural-channel decoding unit 200.

Referring again to FIG. 4, the transmitted downmix signal XT1 is converted to a downmix signal Xq1 in the QMF domain by the domain converting unit 210.

In transmitting the downmix signal XT1 in the time domain to the plural-channel decoding unit 200, at least one of the downmix signal Xq1 and spatial information SI2 can be transmitted to the plural-channel generating unit 230 after completion of time delay compensation.

The plural-channel generating unit 230 can generate a plural-channel audio signal XM1 by combining a transmitted downmix signal Xq1' and spatial information SI2'.

The time delay compensation should be performed on at least one of the downmix signal Xq1 and the spatial information SI2, since the time synchronization between the spatial information and the downmix signal is matched in the QMF domain in encoding. The domain-converted downmix signal Xq1 can be inputted to the plural-channel generating unit 230 after being compensated for the mismatched time synchronization difference in a signal delay processing unit 220.

A method of compensating for the time synchronization difference is to lead the downmix signal Xq1 by the time synchronization difference. In this case, the time synchronization difference can be a total of a delay time generated from the domain converting unit 110 and a delay time of the domain converting unit 210.

It is also possible to compensate for the time synchronization difference by compensating for the time delay of the spatial information SI2. For this case, the spatial information SI2 is lagged by the time synchronization difference in a spatial information delay processing unit 240 and then transmitted to the plural-channel generating unit 230.

A delay value of substantially delayed spatial information corresponds to a total of a mismatched time synchronization difference and a delay time of which time synchronization has been matched. That is, the delayed spatial information is delayed by the encoding delay and the decoding delay. This total also corresponds to a total of the time synchronization difference between the downmix signal and the spatial information generated in the downmix decoding unit 100 (FIG. 1) and the time synchronization difference generated in the plural-channel decoding unit 200.

The delay value of the substantially delayed spatial information SI2 can be determined by considering the performance and delay of a filter (e.g., a QMF, hybrid filter bank).

For instance, a spatial information delay value, which considers performance and delay of a filter, can be 961 time samples. In case of analyzing the delay value of the spatial information, the time synchronization difference generated in the downmix decoding unit 100 is 257 time samples and the time synchronization difference generated in the plural-channel decoding unit 200 is 704 time samples. Although the delay value is represented by a time sample unit, it can be represented by a timeslot unit as well.

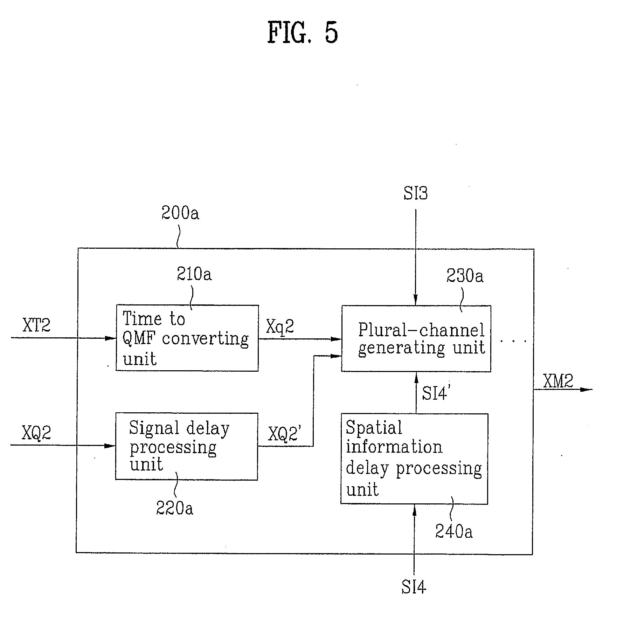

FIG. 5 is a block diagram of the plural-channel decoding unit 200a shown in FIG. 2.

Referring to FIG. 2 and FIG. 5, in a method of processing an audio signal according to one example, the downmix signal processed in the downmix decoding unit 100a can be transmitted to the plural-channel decoding unit 200a in one of two kinds of domains. In the present example, it is assumed that a downmix signal and spatial information are matched together with time synchronization in a QMF domain. Other domains are possible. An audio signal, of which downmix signal and spatial information are matched on a domain different from a time domain, can be processed.

In FIG. 2, the downmix signal XT2 processed in a time domain is transmitted to the plural-channel decoding unit 200a for signal processing.

A downmix signal Xm in an MDCT domain is converted to a downmix signal XT2 in a time domain by the domain converting unit 110a.

The converted downmix signal XT2 is then transmitted to the plural-channel decoding unit 200a.

The transmitted downmix signal XT2 is converted to a downmix signal Xq2 in a QMF domain by the domain converting unit 210a and is then transmitted to a plural-channel generating unit 230a.

The transmitted downmix signal Xq2 is combined with spatial information SI3 in the plural-channel generating unit 230a to generate the plural-channel audio signal XM2.

In this case, the spatial information SI3 is combined with the downmix signal Xq2 after delaying an amount of time corresponding to time synchronization in encoding. The delay can be an encoding delay. Since the spatial information SI3 and the downmix signal Xq2 are matched with time synchronization in encoding, a plural-channel audio signal can be generated without a special synchronization matching process. That is, in this case, the spatial information SI3 is not delayed by a decoding delay.

In some examples, the downmix signal XQ2 processed in a QMF domain is transmitted to the plural-channel decoding unit 200a for signal processing.

The downmix signal Xm processed in an MDCT domain is outputted from a downmix decoding unit 100a. The outputted downmix signal Xm is converted to a downmix signal XQ2 in a QMF domain by the domain converting unit 300a. The converted downmix signal XQ2 is then transmitted to the plural-channel decoding unit 200a.

When the downmix signal XQ2 in the QMF domain is transmitted to the plural-channel decoding unit 200a, at least one of the downmix signal XQ2 or spatial information SI4 can be transmitted to the plural-channel generating unit 230a after completion of time delay compensation.

The plural-channel generating unit 230a can generate the plural-channel audio signal XM2 by combining a transmitted downmix signal XQ2' and spatial information SI4' together.

The reason why the time delay compensation should be performed on at least one of the downmix signal XQ2 and the spatial information SI4 is because time synchronization between the spatial information and the downmix signal is matched in the time domain in encoding. The domain-converted downmix signal XQ2 can be inputted to the plural-channel generating unit 230a after having been compensated for the mismatched time synchronization difference in a signal delay processing unit 220a.

A method of compensating for the time synchronization difference is to lag the downmix signal XQ2 by the time synchronization difference. In this case, the time synchronization difference can be a difference between a delay time generated from the domain converting unit 300a and a total of a delay time generated from the domain converting unit 110a and a delay time generated from the domain converting unit 210a.

It is also possible to compensate for the time synchronization difference by compensating for the time delay of the spatial information SI4. For such a case, the spatial information SI4 is led by the time synchronization difference in a spatial information delay processing unit 240a and then transmitted to the plural-channel generating unit 230a.

A delay value of substantially delayed spatial information corresponds to a total of a mismatched time synchronization difference and a delay time of which time synchronization has been matched. That is, the delayed spatial information SI4' is delayed by the encoding delay and the decoding delay.

A method of processing an audio signal according to one example includes encoding an audio signal of which time synchronization between a downmix signal and spatial information is matched by assuming a specific decoding scheme and decoding the encoded audio signal.

There are several examples of a decoding schemes that are based on quality (e.g., high quality AAC) or based on power (e.g., Low Complexity AAC). The high quality decoding scheme outputs a plural-channel audio signal having audio quality that is more refined than that of the lower power decoding scheme. The lower power decoding scheme has relatively lower power consumption due to its configuration, which is less complicated than that of the high quality decoding scheme.

In the following description, the high quality and low power decoding schemes are used as examples in explaining the present invention. Other decoding schemes are equally applicable to embodiments of the present invention.

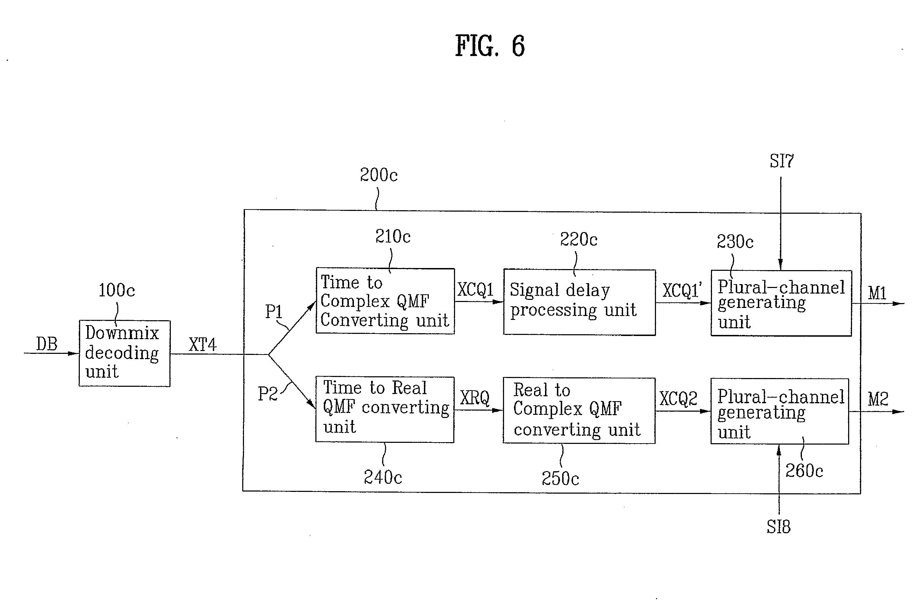

FIG. 6 is a block diagram to explain a method of decoding an audio signal according to another example.

Referring to FIG. 6, a decoding apparatus according to the example includes a downmix decoding unit 100c and a plural-channel decoding unit 200c.

In some examples, a downmix signal XT4 processed in the downmix decoding unit 100c is transmitted to the plural-channel decoding unit 200c, where the signal is combined with spatial information SI7 or SI8 to generate a plural-channel audio signal M1 or M2. In this case, the processed downmix signal XT4 is a downmix signal in a time domain.

An encoded downmix signal DB is transmitted to the downmix decoding unit 100c and processed. The processed downmix signal XT4 is transmitted to the plural-channel decoding unit 200c, which generates a plural-channel audio signal according to one of two kinds of decoding schemes: a high quality decoding scheme and a low power decoding scheme.

In case that the processed downmix signal XT4 is decoded by the low power decoding scheme, the downmix signal XT4 is transmitted and decoded along a path P2. The processed downmix signal XT4 is converted to a signal XRQ in a real QMF domain by a domain converting unit 240c.

The converted downmix signal XRQ is converted to a signal XQC2 in a complex QMF domain by a domain converting unit 250c. The XRQ downmix signal to the XQC2 downmix signal conversion is an example of complexity domain conversion.

Subsequently, the signal XQC2 in the complex QMF domain is combined with spatial information SI8 in a plural-channel generating unit 260c to generate the plural-channel audio signal M2.

Thus, in decoding the downmix signal XT4 by the low power decoding scheme, a separate delay processing procedure is not needed. This is because the time synchronization between the downmix signal and the spatial information is already matched according to the low power decoding scheme in audio signal encoding. That is, in this case, the downmix signal XRQ is not delayed by a decoding delay.

In case that the processed downmix signal XT4 is decoded by the high quality decoding scheme, the downmix signal XT4 is transmitted and decoded along a path P1. The processed downmix signal XT4 is converted to a signal XCQ1 in a complex QMF domain by a domain converting unit 210c.

The converted downmix signal XCQ1 is then delayed by a time delay difference between the downmix signal XCQ1 and spatial information SI7 in a signal delay processing unit 220c.

Subsequently, the delayed downmix signal XCQ1' is combined with spatial information SI7 in a plural-channel generating unit 230c, which generates the plural-channel audio signal M1.

Thus, the downmix signal XCQ1 passes through the signal delay processing unit 220c. This is because a time synchronization difference between the downmix signal XCQ1 and the spatial information SI7 is generated due to the encoding of the audio signal on the assumption that a low power decoding scheme will be used.

The time synchronization difference is a time delay difference, which depends on the decoding scheme that is used. For example, the time delay difference occurs because the decoding process of, for example, a low power decoding scheme is different than a decoding process of a high quality decoding scheme. The time delay difference is considered until a time point of combining a downmix signal and spatial information, since it may not be necessary to synchronize the downmix signal and spatial information after the time point of combining the downmix signal and the spatial information.

In FIG. 6, the time synchronization difference is a difference between a first delay time occurring until a time point of combining the downmix signal XCQ2 and the spatial information SI8 and a second delay time occurring until a time point of combining the downmix signal XCQ1' and the spatial information SI7. In this case, a time sample or timeslot can be used as a unit of time delay.

If the delay time occurring in the domain converting unit 210c is equal to the delay time occurring in the domain converting unit 240c, it is enough for the signal delay processing unit 220c to delay the downmix signal XCQ1 by the delay time occurring in the domain converting unit 250c.

According to the example shown in FIG. 6, the two decoding schemes are included in the plural-channel decoding unit 200c. Alternatively, one decoding scheme can be included in the plural-channel decoding unit 200c.

In the above-explained example, the time synchronization between the downmix signal and the spatial information is matched in accordance with the low power decoding scheme. Yet, the example further includes the case that the time synchronization between the downmix signal and the spatial information is matched in accordance with the high quality decoding scheme. In this case, the downmix signal is led in a manner opposite to the case of matching the time synchronization by the low power decoding scheme.

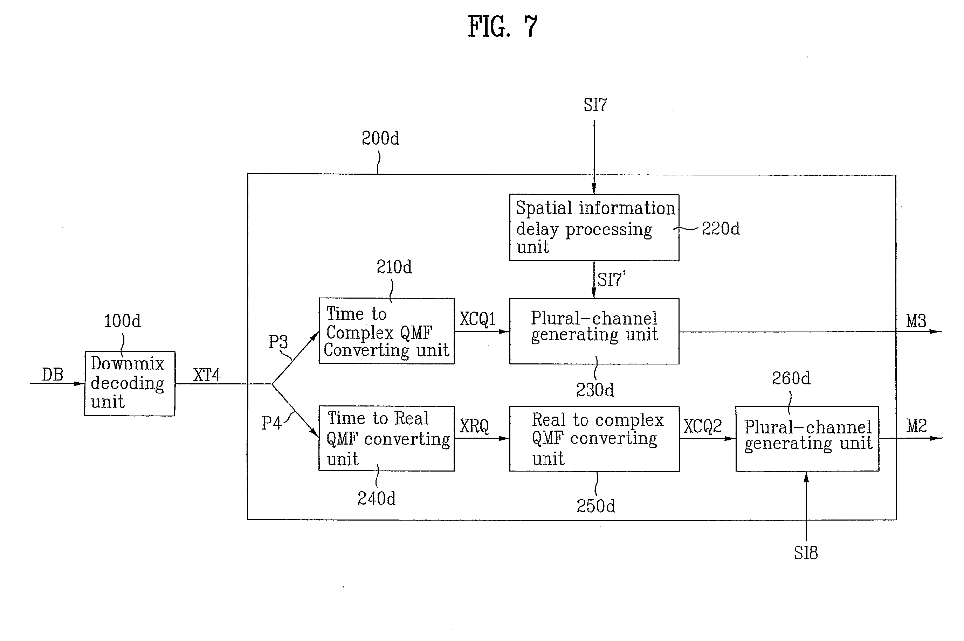

FIG. 7 is a block diagram to explain a method of decoding an audio signal according to another example.

Referring to FIG. 7, a decoding apparatus according to the example includes a downmix decoding unit 100d and a plural-channel decoding unit 200d.

A downmix signal XT4 processed in the downmix decoding unit 100d is transmitted to the plural-channel decoding unit 200d, where the downmix signal is combined with spatial information SI7' or SI8 to generate a plural-channel audio signal M3 or M2. In this case, the processed downmix signal XT4 is a signal in a time domain.

An encoded downmix signal DB is transmitted to the downmix decoding unit 100d and processed. The processed downmix signal XT4 is transmitted to the plural-channel decoding unit 200d, which generates a plural-channel audio signal according to one of two kinds of decoding schemes: a high quality decoding scheme and a low power decoding scheme.

In case that the processed downmix signal XT4 is decoded by the low power decoding scheme, the downmix signal XT4 is transmitted and decoded along a path P4. The processed downmix signal XT4 is converted to a signal XRQ in a real QMF domain by a domain converting unit 240d.

The converted downmix signal XRQ is converted to a signal XQC2 in a complex QMF domain by a domain converting unit 250d. The XRQ downmix signal to the XCQ2 downmix signal conversion is an example of complexity domain conversion.

Subsequently, the signal XQC2 in the complex QMF domain is combined with spatial information SI8 in a plural-channel generating unit 260d to generate the plural-channel audio signal M2.

Thus, in decoding the downmix signal XT4 by the low power decoding scheme, a separate delay processing procedure is not needed. This is because the time synchronization between the downmix signal and the spatial information is already matched according to the low power decoding scheme in audio signal encoding. That is, in this case, the spatial information SI8 is not delayed by a decoding delay.

In case that the processed downmix signal XT4 is decoded by the high quality decoding scheme, the downmix signal XT4 is transmitted and decoded along a path P3. The processed downmix signal XT4 is converted to a signal XCQ1 in a complex QMF domain by a domain converting unit 210d.

The converted downmix signal XCQ1 is transmitted to a plural-channel generating unit 230d, where it is combined with the spatial information SI7' to generate the plural-channel audio signal M3. In this case, the spatial information SI7' is the spatial information of which time delay is compensated for as the spatial information SI7 passes through a spatial information delay processing unit 220d.

Thus, the spatial information SI7 passes through the spatial information delay processing unit 220d. This is because a time synchronization difference between the downmix signal XCQ1 and the spatial information SI7 is generated due to the encoding of the audio signal on the assumption that a low power decoding scheme will be used.

The time synchronization difference is a time delay difference, which depends on the decoding scheme that is used. For example, the time delay difference occurs because the decoding process of, for example, a low power decoding scheme is different than a decoding process of a high quality decoding scheme. The time delay difference is considered until a time point of combining a downmix signal and spatial information, since it is not necessary to synchronize the downmix signal and spatial information after the time point of combining the downmix signal and the spatial information.

In FIG. 7, the time synchronization difference is a difference between a first delay time occurring until a time point of combining the downmix signal XCQ2 and the spatial information SI8 and a second delay time occurring until a time point of combining the downmix signal XCQ1 and the spatial information SI7'. In this case, a time sample or timeslot can be used as a unit of time delay.

If the delay time occurring in the domain converting unit 210d is equal to the delay time occurring in the domain converting unit 240d, it is enough for the spatial information delay processing unit 220d to lead the spatial information SI7 by the delay time occurring in the domain converting unit 250d.

In the example shown, the two decoding schemes are included in the plural-channel decoding unit 200d. Alternatively, one decoding scheme can be included in the plural-channel decoding unit 200d.

In the above-explained example, the time synchronization between the downmix signal and the spatial information is matched in accordance with the low power decoding scheme. Yet, the present example further includes the case that the time synchronization between the downmix signal and the spatial information is matched in accordance with the high quality decoding scheme. In this case, the downmix signal is lagged in a manner opposite to the case of matching the time synchronization by the low power decoding scheme.

Although FIG. 6 and FIG. 7 exemplarily show that one of the signal delay processing unit 220c and the spatial information delay unit 220d is included in the plural-channel decoding unit 200c or 200d, the example includes an embodiment where the spatial information delay processing unit 220d and the signal delay processing unit 220c are included in the plural-channel decoding unit 200c or 200d. In this case, a total of a delay compensation time in the spatial information delay processing unit 220d and a delay compensation time in the signal delay processing unit 220c should be equal to the time synchronization difference.

Explained in the above description are the method of compensating for the time synchronization difference due to the existence of a plurality of the downmix input domains and the method of compensating for the time synchronization difference due to the presence of a plurality of the decoding schemes.

A method of compensating for a time synchronization difference due to the existence of a plurality of downmix input domains and the existence of a plurality of decoding schemes is explained as follows.

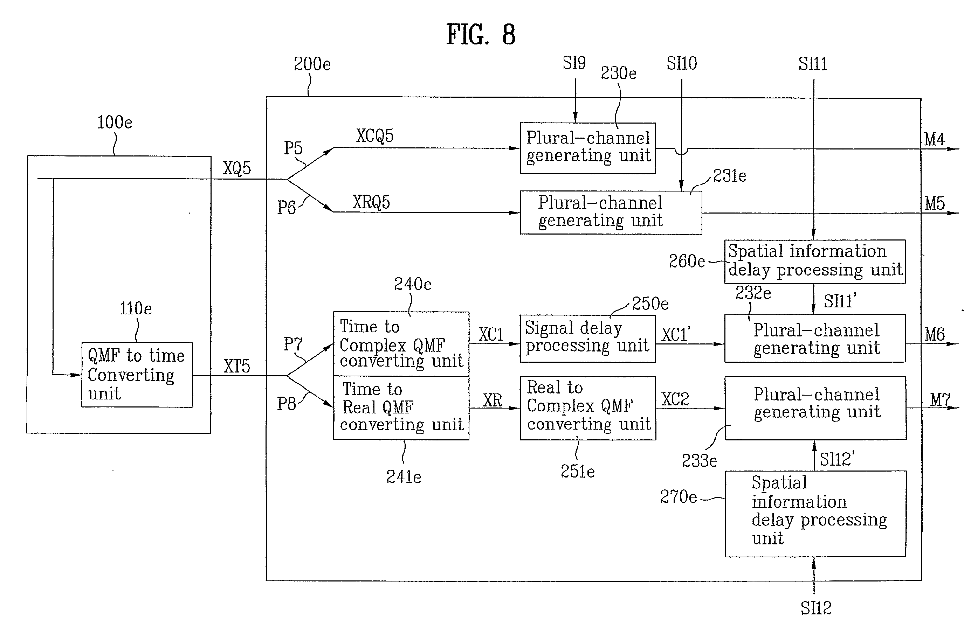

FIG. 8 is a block diagram to explain a method of decoding an audio signal according to one example.

Referring to FIG. 8, a decoding apparatus according to the example includes a downmix decoding unit 100e and a plural-channel decoding unit 200e.

In a method of processing an audio signal according to example, a downmix signal processed in the downmix decoding unit 100e can be transmitted to the plural-channel decoding unit 200e in one of two kinds of domains. In the present embodiment, it is assumed that time synchronization between a downmix signal ) and spatial information is matched on a QMF domain with reference to a low power decoding scheme. Alternatively, various modifications can be applied to the example.

A method that a downmix signal XQ5 processed in a QMF domain is processed by being transmitted to the plural-channel decoding unit 200e is explained as follows. In this case, the downmix signal XQ5 can be any one of a complex QMF signal XCQ5 and real QMF single XRQ5. The XCQ5 is processed by the high quality decoding scheme in the downmix decoding unit 100e. The XRQ5 is processed by the low power decoding scheme in the downmix decoding unit 100e.

In the example, it is assumed that a signal processed by a high quality decoding scheme in the downmix decoding unit 100e is connected to the plural-channel decoding unit 200e of the high quality decoding scheme, and a signal processed by the low power decoding scheme in the downmix decoding unit 100e is connected to the plural-channel decoding unit 200e of the low power decoding scheme. Alternatively, various modifications can be applied to the example.

In case that the processed downmix signal XQ5 is decoded by the low power decoding scheme, the downmix signal XQ5 is transmitted and decoded along a path P6. In this case, the XQ5 is a downmix signal XRQ5 in a real QMF domain.

The downmix signal XRQ5 is combined with spatial information SI10 in a multi-channel generating unit 231e to generate a multi-channel audio signal M5.

Thus, in decoding the downmix signal XQ5 by the low power decoding scheme, a separate delay processing procedure is not needed. This is because the time synchronization between the downmix signal and the spatial information is already matched according to the low power decoding scheme in audio signal encoding.

In case that the processed downmix signal XQ5 is decoded by the high quality decoding scheme, the downmix signal XQ5 is transmitted and decoded along a path P5. In this case, the XQ5 is a downmix signal XCQ5 in a complex QMF domain. The downmix signal XCQ5 is combined with the spatial information SI9 in a multi-channel generating unit 230e to generate a multi-channel audio signal M4.

Explained in the following is a case that a downmix signal XT5 processed in a time domain is transmitted to the plural-channel decoding unit 200e for signal processing.

A downmix signal XT5 processed in the downmix decoding unit 100e is transmitted to the plural-channel decoding unit 200e, where it is combined with spatial information SI11 or SI12 to generate a plural-channel audio signal M6 or M7.

The downmix signal XT5 is transmitted to the plural-channel decoding unit 200e, which generates a plural-channel audio signal according to one of two kinds of decoding schemes: a high quality decoding scheme and a low power decoding scheme.

In case that the processed downmix signal XT5 is decoded by the low power decoding scheme, the downmix signal XT5 is transmitted and decoded along a path P8. The processed downmix signal XT5 is converted to a signal XR in a real QMF domain by a domain converting unit 241e.

The converted downmix signal XR is converted to a signal XC2 in a complex QMF domain by a domain converting unit 250e. The XR downmix signal to the XC2 downmix signal conversion is an example of complexity domain conversion.

Subsequently, the signal XC2 in the complex QMF domain is combined with spatial information SI12' in a plural-channel generating unit 233e, which generates a plural-channel audio signal M7.

In this case, the spatial information SI12' is the spatial information of which time delay is compensated for as the spatial information SI12 passes through a spatial information delay processing unit 240e.

Thus, the spatial information SI12 passes through the spatial information delay processing unit 240e. This is because a time synchronization difference between the downmix signal XC2 and the spatial information SI12 is generated due to the audio signal encoding performed by the low power decoding scheme on the assumption that a domain, of which time synchronization between the downmix signal and the spatial information is matched, is the QMF domain. There the delayed spatial information SI12' is delayed by the encoding delay and the decoding delay.

In case that the processed downmix signal XT5 is decoded by the high quality decoding scheme, the downmix signal XT5 is transmitted and decoded along a path P7. The processed downmix signal XT5 is converted to a signal XC1 in a complex QMF domain by a domain converting unit 240e.

The converted downmix signal XC1 and the spatial information SI11 are compensated for a time delay by a time synchronization difference between the downmix signal XC1 and the spatial information SI11 in a signal delay processing unit 250e and a spatial information delay processing unit 260e, respectively.

Subsequently, the time-delay-compensated downmix signal XC1' is combined with the time-delay-compensated spatial information SI11' in a plural-channel generating unit 232e, which generates a plural-channel audio signal M6.

Thus, the downmix signal XC1 passes through the signal delay processing unit 250e and the spatial information SI11 passes through the spatial information delay processing unit 260e. This is because a time synchronization difference between the downmix signal XC1 and the spatial information SI11 is generated due to the encoding of the audio signal under the assumption of a low power decoding scheme, and on the further assumption that a domain, of which time synchronization between the downmix signal and the spatial information is matched, is the QMF domain.

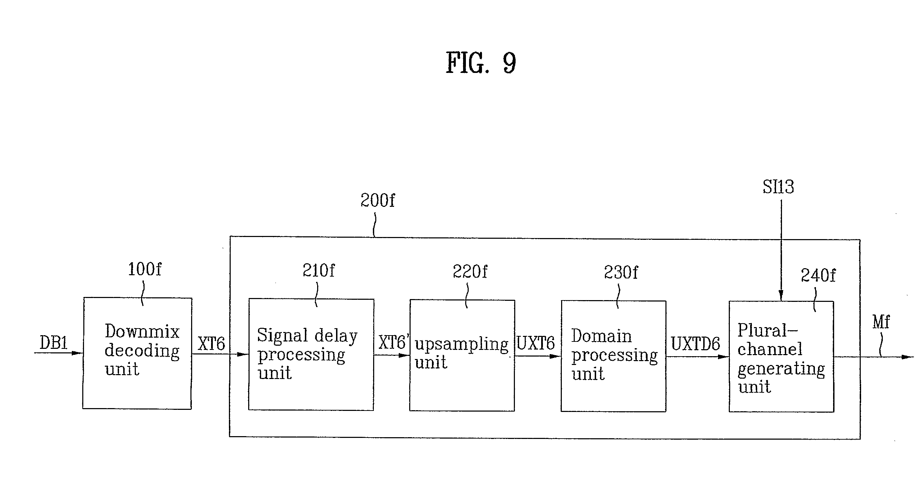

FIG. 9 is a block diagram to explain a method of decoding an audio signal according to one embodiment of the present invention.

Referring to FIG. 9, a decoding apparatus according to the present invention includes a downmix decoding unit 100f and a plural-channel decoding unit 200f.

An encoded downmix signal DB1 is transmitted to the downmix decoding unit 100f and then processed. The downmix signal DB1 is encoded considering two downmix decoding schemes, including a first downmix decoding and a second downmix decoding scheme.

The downmix signal DB1 is processed according to one downmix decoding scheme in downmix decoding unit 100f. The one downmix decoding scheme can be the first downmix decoding scheme.

The processed downmix signal XT6 is transmitted to the plural-channel decoding unit 200f, which generates a plural-channel audio signal Mf.

The processed downmix signal XT6' is delayed by a decoding delay in a signal processing unit 210f. The downmix signal XT6' can be a delayed by a decoding delay. The reason why the downmix signal XT6 is delayed is that the downmix decoding scheme that is accounted for in encoding is different from the downmix decoding scheme used in decoding.

Therefore, it can be necessary to upsample the downmix signal XT6' according to the circumstances.

The delayed downmix signal XT6' is upsampled in upsampling unit 220f. The reason why the downmix signal XT6' is upsampled is that the number of samples of the downmix signal XT6' is different from the number of samples of the spatial information SI13.

The order of the delay processing of the downmix signal XT6 and the upsampling processing of the downmix signal XT6' is interchangeable.

The domain of the upsampled downmix signal UXT6 is converted in domain processing unit 230f. The conversion of the domain of the downmix signal UXT6 can include the F/T domain conversion and the complexity domain conversion.

Subsequently, the domain converted downmix signal UXTD6 is combined with spatial information SI13 in a plural-channel generating unit 260d, which generates the plural-channel audio signal Mf.

Explained in the above description is the method of compensating for the time synchronization difference generated between the downmix signal and the spatial information.

Explained in the following description is a method of compensating for a time synchronization difference generated between time series data and a plural-channel audio signal generated by one of the aforesaid methods.

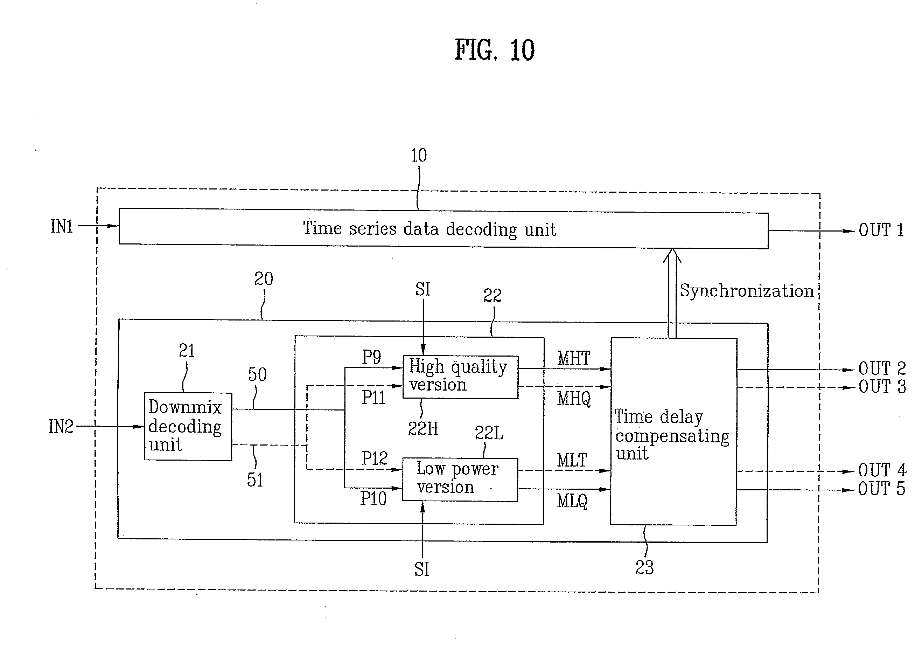

FIG. 10 is a block diagram of an apparatus for decoding an audio signal according to one example.

Referring to FIG. 10, an apparatus for decoding an audio signal according to one example includes a time series data decoding unit 10 and a plural-channel audio signal processing unit 20.

The plural-channel audio signal processing unit 20 includes a downmix decoding unit 21, a plural-channel decoding unit 22 and a time delay compensating unit 23.

A downmix bitstream IN2, which is an example of an encoded downmix signal, is inputted to the downmix decoding unit 21 to be decoded.

In this case, the downmix bit stream IN2 can be decoded and outputted in two kinds of domains. The output available domains include a time domain and a QMF domain. A reference number '50' indicates a downmix signal decoded and outputted in a time domain and a reference number '51' indicates a downmix signal decoded and outputted in a QMF domain. In the present example, two kinds of domains are described. The present example, however, includes downmix signals decoded and outputted on other kinds of domains.

The downmix signals 50 and 51 are transmitted to the plural-channel decoding unit 22 and then decoded according to two kinds of decoding schemes 22H and 22L, respectively. In this case, the reference number '22H' indicates a high quality decoding scheme and the reference number '22L' indicates a low power decoding scheme.

In this example, only two kinds of decoding schemes are employed. The present example, however, is able to employ more decoding schemes.

The downmix signal 50 decoded and outputted in the time domain is decoded according to a selection of one of two paths P9 and P10. In this case, the path P9 indicates a path for decoding by the high quality decoding scheme 22H and the path P10 indicates a path for decoding by the low power decoding scheme 22L.

The downmix signal 50 transmitted along the path P9 is combined with spatial information SI according to the high quality decoding scheme 22H to generate a plural-channel audio signal MHT. The downmix signal 50 transmitted along the path P10 is combined with spatial information SI according to the low power decoding scheme 22L to generate a plural-channel audio signal MLT.

The other downmix signal 51 decoded and outputted in the QMF domain is decoded according to a selection of one of two paths P11 and P12. In this case, the path P11 indicates a path for decoding by the high quality decoding scheme 22H and the path P12 indicates a path for decoding by the low power decoding scheme 22L.

The downmix signal 51 transmitted along the path P11 is combined with spatial information SI according to the high quality decoding scheme 22H to generate a plural-channel audio signal MHQ. The downmix signal 51 transmitted along the path P12 is combined with spatial information SI according to the low power decoding scheme 22L to generate a plural-channel audio signal MLQ.

At least one of the plural-channel audio signals MHT, MHQ, MLT and MLQ generated by the above-explained methods undergoes a time delay compensating process in the time delay compensating unit 23 and is then outputted as OUT2, OUT3, OUT4 or OUT5.

In the present example, the time delay compensating process is able to prevent a time delay from occurring in a manner of comparing a time synchronization mismatched plural-channel audio signal MHQ, MLT or MKQ to a plural-channel audio signal MHT on the assumption that a time synchronization between time-series data OUT1 decoded and outputted in the time series decoding unit 10 and the aforesaid plural-channel audio signal MHT is matched. Of course, if a time synchronization between the time series data OUT1 and one of the plural-channel audio signals MHQ, MLT and MLQ except the aforesaid plural-channel audio signal MHT is matched, a time synchronization with the time series data OUT1 can be matched by compensating for a time delay of one of the rest of the plural-channel audio signals of which time synchronization is mismatched.

The example can also perform the time delay compensating process in case that the time series data OUT1 and the plural-channel audio signal MHT, MHQ, MLT or MLQ are not processed together. For instance, a time delay of the plural-channel audio signal is compensated and is prevented from occurring using a result of comparison with the plural-channel audio signal MLT. This can be diversified in various ways.

It will be apparent to those skilled in the art that various modifications and variations can be made in the present invention without departing from the scope of the invention. Thus, it is intended that the present invention covers the modifications and variations of this invention provided they come within the scope of the appended claims.

### Industrial Applicability

Accordingly, the present invention provides the following effects or advantages.

First, if a time synchronization difference between a downmix signal and spatial information is generated, the present invention prevents audio quality degradation by compensating for the time synchronization difference.

Second, the present invention is able to compensate for a time synchronization difference between time series data and a plural-channel audio signal to be processed together with the time series data of a moving picture, a text, a still image and the like.

## Claims

1. A method of processing an audio signal, comprising:
receiving an audio signal, the audio signal including a downmix signal (DB1) encoded by taking account a second downmix decoding scheme selected among a first downmix decoding scheme and the second downmix decoding scheme, and spatial information (SI13) to generate a plural-channel audio signal (Mf), the downmix signal (DB1) being generated by downmixing a plural-channel audio signal (Mf) and encoded with the spatial information in a time synchronized manner;
decoding the downmix signal (DB1) according to the first downmix decoding scheme;
delaying the decoded downmix signal (XT6) by a decoding delay for compensating a different downmix decoding scheme accounted for in encoding the audio signal,
**characterized by**:
upsampling a number of samples of the delayed downmix signal (XT6') to be identical to a number of samples of the spatial information (SI13);
domain converting the upsampled downmix signal (UXT6); and
generating the plural-channel audio signal (Mf) by combining the converted downmix signal (UXTD6) with the spatial information (SI13).

2. The method of claim 1, wherein the domain converting comprises converting from a frequency domain to a time domain.

3. An apparatus for processing an audio signal, comprising:
a downmix decoding unit (100f) adapted to:
receive a downmix signal (DB1) encoded by taking account a second downmix decoding scheme selected among a first downmix decoding scheme and the second downmix decoding scheme, the downmix signal (DB1) being generated by downmixing a plural-channel signal (Mf) and encoded with spatial information (SI13) in a time synchronized manner, and
decode the downmix signal (DB1) according to a first downmix decoding scheme;
a signal delay processing unit (210f) adapted to delay the decoded downmix signal (XT6) by a decoding delay for compensating a different downmix decoding scheme accounted for in encoding the audio signal, **characterized by**:
an upsampling unit (220f) adapted to upsample a number of samples of the delayed downmix signal (XT6') to be identical to a number of samples of the spatial information (SI13);
a domain converting unit (230f) adapted to domain convert the upsampled downmix signal (UXT6); and
a plural-channel generating unit (240f) adapted to receive the spatial information (SI13) to generate the plural-channel audio signal (Mf) and generate the plural-channel audio signal (Mf) by combining the converted downmix signal (UXTD6) with the spatial information (SI13).

4. The apparatus of claim 3, wherein the domain converting unit converts from a frequency domain to a time domain.

5. A computer-readable medium having instructions stored thereon, which, when executed by a processor, causes the processor to perform:
receiving an audio signal including a downmix signal (DB1) encoded by taking account a second downmix decoding scheme selected among a first downmix decoding scheme and the second downmix decoding scheme, and spatial information (SI13) to generate a plural-channel audio signal (Mf), the downmix signal (DB1) being generated by downmixing a plural-channel signal (Mf) and encoded with the spatial information in a time synchronized manner;
decoding the downmix signal (DB1) according to a first downmix coding scheme;
delaying the decoded downmix signal (XT6) by a decoding delay for compensating a different downmix decoding scheme accounted for in encoding the audio signal,
**characterized by**:
upsampling a number of samples of the delayed downmix signal(XT6') to be identical to a number of samples of the spatial information (SI13);
domain converting the upsampled downmix signal (UXT6); and
generating the plural-channel audio signal (Mf) by combining the converted downmix signal (UXTD6) with the spatial information (SI13).

## Patentansprüche

1. Verfahren zur Verarbeitung eines Audiosignals, umfassend:
Empfangen eines Audiosignals, wobei das Audiosignal ein Downmix-Signal (DB1), welches unter Berücksichtigung eines zweiten Downmix-Dekodierschemas kodiert wurde, dass aus einem ersten Downmix-Dekodierschema und dem zweiten Downmix-Dekodierschema gewählt wurde, sowie Rauminformation (SI13) enthält, um ein Mehrkanal-Audiosignal (Mf) zu erzeugen, wobei das Downmix-Signal (DB1) durch Herabmischen eines Mehrkanal-Audiosignals (Mf) erzeugt wurde und mit der Rauminformation in zeitsynchronisierter Weise kodiert wurde,
Dekodieren des Downmix-Signals (DB1) nach Maßgabe des ersten Downmix-Dekodierschemas,
Verzögern des dekodierten Downmix-Signals (XT6) um eine Dekodierverzögerung zur Kompensation eines anderen Downmix-Dekodierschemas, dem bei der Kodierung des Audiosignals Rechnung getragen wurde,
**gekennzeichnet durch**:
Upsampling einer Anzahl Abtastwerte des verzögerten Downmix-Signals (XT6'), die identisch zu einer Anzahl Abtastwerte der Rauminformation (SI13) ist,
Bereichswandeln des upgesampelten Downmix-Signals (UXT6) und Erzeugen des Mehrkanal-Audiosignals (Mf) **durch** Kombinieren des gewandelten Downmix-Signals (UXTD6) mit der Rauminformation (SI13).

2. Verfahren nach Anspruch 1, wobei das Bereichswandeln ein Wandeln von einem Frequenzbereich in einen Zeitbereich umfasst.

3. Vorrichtung zur Verarbeitung eines Audiosignals, umfassend:
eine Downmix-Dekodiereinheit (100f), welche dazu ausgelegt ist:
ein Downmix-Signal (DB1) zu empfangen, welches unter Berücksichtigung eines zweiten Downmix-Dekodierschemas, das aus einem ersten Downmix-Dekodierschema und dem zweiten Downmix-Dekodierschema ausgewählt wurde, kodiert wurde, wobei das Downmix-Signal (DB1) durch Herabmischen eines Mehrkanal-Signals (Mf) erzeugt wurde und mit Rauminformation (SI13) in zeitsynchronisierter Weise kodiert wurde, und
das Downmix-Signal (DB1) nach Maßgabe eines ersten Downmix-Dekodierschemas zu dekodieren,
eine Signalverzögerungsverarbeitungseinheit (210f), welche dazu ausgebildet ist, das dekodierte Downmix-Signal (XT6) um eine Dekodierverzögerung zwecks Kompensation eines anderen Downmix-Dekodierschemas zu verzögern, dem bei der Dekodierung des Audiosignals Rechnung getragen wurde, **gekennzeichnet durch**:
eine Upsamling-Einheit (220f), welche dazu ausgelegt ist, eine Anzahl von Abtastwerten des verzögerten Downmix-Signals (XT6'), die identisch ist zu einer Anzahl von Abtastwerten der Rauminformation (SI13), upzusampeln,
eine Bereichswandlungseinheit (230f), welche dazu ausgelegt ist, das upgesampelte Downmix-Signal (UXT6) bereichsmäßig zu wandeln, und
eine Mehrkanal-Erzeugungseinheit (240f), welche dazu ausgelegt ist, die Rauminformation (SI13) zu empfangen, um das Mehrkanal-Audiosignal (Mf) zu erzeugen und das Mehrkanal-Audiosignal (Mf) **durch** Kombinieren des gewandelten Downmix-Signals (UXTD6) mit der Rauminformation (SI13) zu erzeugen.

4. Vorrichtung nach Anspruch 3, wobei die Bereichswandlungseinheit von einem Frequenzbereich in einen Zeitbereich wandelt.

5. Computerlesbares Medium mit darin gespeicherten Instruktionen, welche bei Ausführung durch einen Prozessor den Prozessor dazu veranlassen, folgendes durchzuführen:
Empfangen eines Audiosignals, wobei das Audiosignal ein Downmix-Signal (DB1),
welches unter Berücksichtigung eines zweiten Downmix-Dekodierschemas kodiert wurde, dass aus einem ersten Downmix-Dekodierschema und dem zweiten Downmix-Dekodierschema gewählt wurde, sowie Rauminformation (SI13) enthält,
um ein Mehrkanal-Audiosignal (Mf) zu erzeugen, wobei das Downmix-Signal (DB1) durch Herabmischen eines Mehrkanal-Audiosignals (Mf) erzeugt wurde und mit der Rauminformation in zeitsynchronisierter Weise kodiert wurde,
Dekodieren des Downmix-Signals (DB1) nach Maßgabe eines ersten Downmix-Dekodierschemas,
Verzögern des dekodierten Downmix-Signals (XT6) um eine Dekodierverzögerung zur Kompensation eines anderen Downmix-Dekodierschemas, dem bei der Kodierung des Audiosignals Rechnung getragen wurde,
**gekennzeichnet durch**:
Upsampling einer Anzahl Abtastwerte des verzögerten Downmix-Signals (XT6'),
die identisch zu einer Anzahl Abtastwerte der Rauminformation (SI13) ist,
Bereichswandeln des upgesampelten Downmix-Signals (UXT6) und Erzeugen des Mehrkanal-Audiosignals (Mf) **durch** Kombinieren des gewandelten Downmix-Signals (UXTD6) mit der Rauminformation (SI13).

## Revendications

1. Procédé de traitement d'un signal audio, comprenant les étapes consistant à :
recevoir un signal audio, le signal audio incluant un signal de sous-mixage (DB1) codé en prenant en compte un deuxième schéma de décodage de sous-mixage sélectionné parmi un premier schéma de décodage de sous-mixage et le deuxième schéma de décodage de sous-mixage, et des informations spatiales (SI13) pour générer un signal audio multicanaux (Mf), le signal de sous-mixage (DB1) étant généré en sous-mixant un signal audio multicanaux (Mf) et codé avec les informations spatiales d'une manière synchronisée dans le temps ;
décoder le signal de sous-mixage (DB1) conformément au premier schéma de décodage de sous-mixage ;
retarder le signal de sous-mixage décodé (XT6) par un retard de décodage pour compenser un schéma de décodage de sous-mixage différent pris en compte pour coder le signal audio,
**caractérisé par** les étapes consistant à :
suréchantillonner un nombre d'échantillons du signal de sous-mixage retardé (XT6') pour qu'il soit identique à un nombre d'échantillons des informations spatiales (SI13) ;
convertir le domaine du signal de sous-mixage suréchantillonné (UXT6) ; et
générer le signal audio multicanaux (Mf) en combinant le signal de sous-mixage converti (UXTD6) avec les informations spatiales (SI13).

2. Procédé selon la revendication 1, dans lequel la conversion de domaine comprend la conversion d'un domaine fréquentiel à un domaine temporel.

3. Appareil de traitement d'un signal audio, comprenant :
une unité de décodage de sous-mixage (100f) adaptée pour :
recevoir un signal de sous-mixage (DB1) codé en prenant en compte un deuxième schéma de décodage de sous-mixage sélectionné parmi un premier schéma de décodage de sous-mixage et le deuxième schéma de décodage de sous-mixage, le signal de sous-mixage (DB1) étant généré en sous-mixant un signal multicanaux (Mf) et codé avec des informations spatiales (SI13) d'une manière synchronisée dans le temps ; et
décoder le signal de sous-mixage (DB1) conformément à un premier schéma de décodage de sous-mixage ;
une unité de traitement de retard de signal (210f) adaptée pour retarder le signal de sous-mixage décodé (XT6) par un retard de décodage pour compenser un schéma de décodage de sous-mixage différent pris en compte pour coder le signal audio, **caractérisé par** :
une unité de suréchantillonnage (220f) adaptée pour suréchantillonner un nombre d'échantillons du signal de sous-mixage retardé (XT6') pour qu'il soit identique à un nombre d'échantillons des informations spatiales (SI13) ;
une unité de conversion de domaine (230f) adaptée pour convertir le domaine du signal de sous-mixage suréchantillonné (UXT6) ; et
une unité de génération multicanaux (240f) adaptée pour recevoir les informations spatiales (SI13) pour générer le signal audio multicanaux (Mf) et générer le signal audio multicanaux (Mf) en combinant le signal de sous-mixage converti (UXTD6) avec les informations spatiales (SI13).

4. Appareil selon la revendication 3, dans lequel l'unité de conversion de domaine convertit d'un domaine fréquentiel à un domaine temporel.

5. Support lisible sur ordinateur comportant des instructions stockées sur celui-ci, qui, lorsqu'exécutées par un processeur, amènent le processeur à réaliser les étapes consistant à :
recevoir un signal audio incluant un signal de sous-mixage (DB1) codé en prenant en compte un deuxième schéma de décodage de sous-mixage sélectionné parmi un premier schéma de décodage de sous-mixage et le deuxième schéma de décodage de sous-mixage, et des informations spatiales (SI13) pour générer un signal audio multicanaux (Mf), le signal de sous-mixage (DB1) étant généré en sous-mixant un signal multicanaux (Mf) et codé avec les informations spatiales d'une manière synchronisée dans le temps ;
décoder le signal de sous-mixage (DB1) conformément à un premier schéma de codage de sous-mixage ;
retarder le signal de sous-mixage décodé (XT6) par un retard de décodage pour compenser un schéma de décodage de sous-mixage différent pris en compte pour coder le signal audio,
**caractérisé par** les étapes consistant à :
suréchantillonner un nombre d'échantillons du signal de sous-mixage retardé (XT6') pour qu'il soit identique à un nombre d'échantillons des informations spatiales (SI13) ;
convertir le domaine du signal de sous-mixage suréchantillonné (UXT6) ; et
générer le signal audio multicanaux (Mf) en combinant le signal de sous-mixage converti (UXTD6) avec les informations spatiales (SI13).
